# EUROPEAN PATENT APPLICATION

(11) **EP 4 679 970 A1**
(43) Date of publication of application: **14.01.2026**
(21) Application number: 24187217.5
(22) Date of filing: 08.07.2024
(51) Int. Cl.: H10D 84/03

(54) **DEVICE AND METHOD OF MAKING NANOSHEET BASED DEVICES**

(71) Applicant: Huawei Technologies Co., Ltd., Shenzhen, Guangdong 518129 (CN)
(72) Inventor: Yakimets, Dmitry, 80992 Munich (DE); Bhuwalka, Krishna Kumar, 80992 Munich (DE)
(74) Representative: Körber, Martin Hans

(57) **Abstract**

A semiconductor and method for fabrication of the semiconductor device having a patterned gate to reduce the parasitic capacitance in a field effect transistor ("FET"), particularly a complementary field effect transistor ("CFET"). The patterned gate has edges along the longitudinal axis of the gate from top to bottom that are convex or concave. The gate and semiconductors are electrically isolated by inner and outer spacers.

## Description

### FIELD AND BACKGROUND OF THE INVENTION

The present invention, in some embodiments thereof, relates to a semiconductor device and, more particularly, but not exclusively, to a field effect transistor ("FET").

Additional background art includes U.S. Patent No. 9,601,379 (Pawlak, et al), U.S. Patent No. 10,903,317 (Frougier, et al), U.S.

Patent No. 10,553,696 (Ando, et al), and U.S. Patent Application Publication No. 2019/0288004 (Smith, et al).

### SUMMARY OF THE INVENTION

The invention of this application is directed toward the gate and gate structure of an FET. The technical problem is parasitic capacitance between a gate and source and drain electrodes in a semiconductor device. Although scaling of semiconductor devices dimensions has resulted in their overall performance improvement, parasitic capacitance grows hyperbolically as a function of a distance between gate and source and drain electrodes unless some changes in the design of these electrodes are introduced. The technical solution of this invention is to pattern the gate by etching processes to form concave or convex surfaces of the edges of the gate to reduce capacitance. In addition, there are difficulties in enabling processes resulting in perfectly straight vertical patterning of tall structures like gate. The solution of this invention combines two or more non-straight etching recipes to improve the overall performance. Thus, not only is device performance is improved, but also etching recipes are simplified.

According to an aspect of the present invention some embodiments of the semiconductor device comprising: a substrate; and a fin formed on the substrate; and a source region formed on the substrate at one end of the fin and a drain region formed on the other end of the fin; and a gate formed around the fin, wherein the gate comprises opposing edges extending from top to bottom of the gate, wherein the opposing edges of the gate along the fin have a concave or convex profile from top to bottom of the gate.

According to some embodiments of the invention, according to the first aspect of the invention each of the opposing edges comprises an upper section and a lower section from top to bottom of the gate, and wherein the upper section and the lower section have different edge profile along the fin.

According to some embodiments of the first aspect of the invention each of the opposing edges comprises a top section, a middle section and a bottom section from top to bottom of the gate and wherein the middle section is narrower or wider than the top section and the bottom section along the fin.

According to some embodiments of the first aspect of the invention each of the opposing edges has a curved surface with a different radius of curvature from top to bottom of the gate.

According to some embodiments of the first aspect of the invention each of the opposing edges has a curved surface with a different radius of curvature from top to bottom of the gate.

According to some embodiments of the first aspect of the invention the upper section has a linear profile tapered from top to bottom of the upper section and the lower section has a linear profile tapered from bottom to top of the lower section. According to some embodiments of the first aspect of the invention the fin comprises a plurality of semiconductor channels being stacked on top of each other, and wherein the plurality of channels is wrapped by an electrode of the gate from all sides.

According to some embodiments of the first aspect of the invention both the source region and the drain region comprise of two electrically isolated sub-regions, each sub-region being vertically stacked, wherein the one of the subregions is n-doped forming a NMOS device and the other subregion is p-doped forming a PMOS device.

According to some embodiments of the first aspect of the invention the gates, source region and drain region isolated from each other by spacers, wherein the spacers define dielectric spaces between conducting features.

According to some embodiments of the first aspect of the invention and described in the previous embodiment, the spacers are formed on the side of the gates around the fin are outer spacers.

According to some embodiments of the first aspect of the invention and described in the previous embodiments, the spacers between channels are inner spacers, wherein thickness of the inner spacers defines to which extend the metal gate electrode protrudes towards the source and drain regions thus effectively defining the gate length.

According to some embodiments of the first aspect of the invention and described in the previous embodiments the spacers formed in between the channels within the fin region are inner spacers. The inner spacers in some embodiments controlling the extension of the gate electrode towards source and drain regions.

According to some embodiments of the first aspect of the invention and described in the previous embodiments the dielectric is a high-K dielectric.

According to another aspect of some embodiments of the present invention there is provided a method for fabricating a semiconductor device, comprising: providing a substrate; and forming a fin on the substrate; and forming a source region at one end of the fin and a drain region on the other end of the fin, and forming a gate around the fin, wherein the gate comprises opposing edges extending from top to bottom of the gate, wherein forming the gate around the fin comprises patterning the opposing edges of the gate along the fin with two or more etching processes being performed successively, so that the opposing edges of the gate along the fin have a concave or convex profile from top to bottom of the gate.

A method for fabricating a semiconductor device according to the second aspect of the present invention, wherein the patterning the opposing edges comprises: performing a first etching process to form an upper section of the opposing edges of the gate; and performing a second etching process to form a lower section of the opposing edges of the gate, wherein the first etching processes and the second etching process forms the upper section and the lower sections of the gate have different edge profiles along the fin.

A method for fabricating a semiconductor device according to the second aspect of the present invention, wherein the upper section has a linear profile tapered from top to bottom of the upper section and the lower section has a linear profile tapered from bottom to top of the lower section.

A method for fabricating a semiconductor device according to the second aspect of the present invention, wherein patterning the opposing edges comprises: performing a first etching process to form a top section of the opposing edges of the gate; and performing a second etching process to form a middle section of the opposing edges of the gate; and performing a third etching process to form a bottom section of the opposing edges of the gate, wherein the first etching processes, the second etching process and the third etching process are different in applied etchant, or etching time so that the middle section is narrower or wider than the top section and the bottom section along the fm.

Unless otherwise defined, all technical and/or scientific terms used herein have the same meaning as commonly understood by one of ordinary skill in the art to which the invention pertains. Although methods and materials similar or equivalent to those described herein can be used in the practice or testing of embodiments of the invention, exemplary methods and/or materials are described below. In case of conflict, the patent specification, including definitions, will control. In addition, the materials, methods, and examples are illustrative only and are not intended to be necessarily limiting.

### BRIEF DESCRIPTION OF THE SEVERAL VIEWS OF THE DRAWINGS

Some embodiments of the invention are herein described, by way of example only, with reference to the accompanying drawings. With specific reference now to the drawings in detail, it is stressed that the particulars shown are by way of example and for purposes of illustrative discussion of embodiments of the invention. In this regard, the description taken with the drawings makes apparent to those skilled in the art how embodiments of the invention may be practiced. The drawings are not to scale unless otherwise indicated.
FIG. 1 is a simplified illustration of the device from a top view with Axis A'-A' is along an offset of the fin (104) and Axis B'-B' is along the fin (104);
FIG. 2A is a side plan view along the fin;
FIG. 2B is a side plan view of the tapered gate along an offset axis of the fin;
FIG. 3A is a side plan view along the fin with inner spacers;
FIG. 3B is a side plan view along the offset axis of the fin with inner spacers;
FIG. 4A is a side plan view of the device along the fin axis in final form;
FIG. 4B is a side plan view of the device with along the offset axis in final form; and
FIG. 5 is a cutaway perspective view of device.

### DESCRIPTION OF SPECIFIC EMBODIMENTS OF THE INVENTION

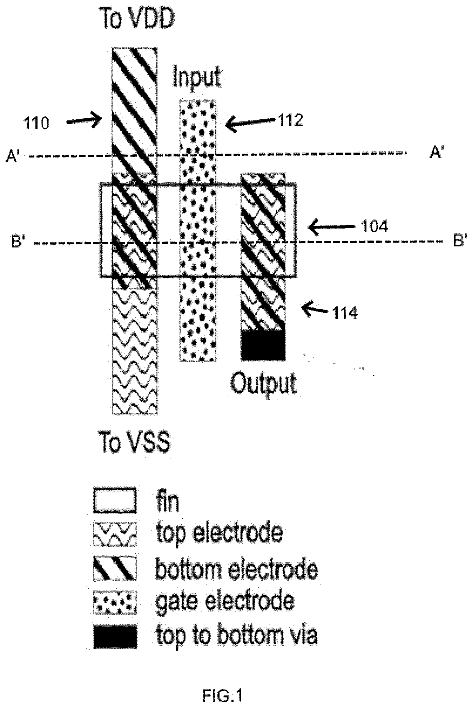

For purposes of better understanding some embodiments of the present invention, as illustrated in Figures 1-8 of the drawings, reference is first made to the construction and operation of embodiments of the invention.

Before explaining at least one embodiment of the invention in detail, it is to be understood that the invention is not necessarily limited in its application to the details of construction and the arrangement of the components and/or methods set forth in the following description and/or illustrated in the drawings and/or the Examples. The invention is capable of other embodiments or of being practiced or carried out in various ways.

It is expected that during the life of a patent maturing from this application many relevant FET including Complementary Field Effect Transistor ("CFET") semiconductor devices will be developed and the scope of the term the patterned gate is intended to include all such new technologies *a priori.*

The technical problem of capacitance, particularly parasitic capacitance, is exacerbated as the scale of semiconductor is reduced. The scaled dimensions of Gate All Around ("GAA") devices result in a problem with too high parasitic capacitance. The solution to reduce parasitic capacitance is to pattern the side edges of the semiconductor gate.

The patterning is performed by etching. More than one etching forms opposite gate edge surfaces. The edge surfaces are convex or concave. As a result of this patterning the middle section of the gate is either wider or narrower than the width of the top and bottom sections of the gate. Where there are more than two etching, a third or more surfaces are patterned. "Convex or concave" includes tapers, curved surfaces with positive or negative radii of curvature. Typically, the gate edge surfaces are straight and normal to the top and bottom edge surfaces.

The semiconductor device in one embodiment is a FET and can be a GAA. A GAA FET has the metal gate, wrapping channels from all the sides and isolated from them by thin gate Negative Field Effect Transistor ("NFET") or Positive Field Effect Transistor ("PFET") each comprised of at least one channel. The invention provides for a complementary FET ("CFET"). The CFET is comprised on an NMOS device stacked on top a PMOS device or *vice versa* with gate electrode shared between both devices.

As gate electrode is thin on top and bottom (for convex shape) or in the middle (for concave shape), it does not provide sufficient control over the channels in these thin regions. Process flow for the GAA FETs features inner spacers in between the channels within the fin region. These inner spacers control the extension of the gate electrode towards source and drain regions and allow to regain control of the channels.

Both inner and outer spacers electrically isolate and are positioned between the gate(s) and the source and drain regions. Outer spacers are formed by conformal deposition around the gate.

FIG. 1is an illustration of the CFET device from a top plan view showing the source region (110), gate (112) for signal input, and drain output region (114). The fin (104) is normal to these elements. The bottom and top sub-regions of the source are connected to with electrodes to VDD and VSS power supply, respectively. The axis of the fin (104), showing the source (106) and gate (108). Axis A'-A' is along an offset of the fin (104) and Axis B'-B' is along the fin (104).

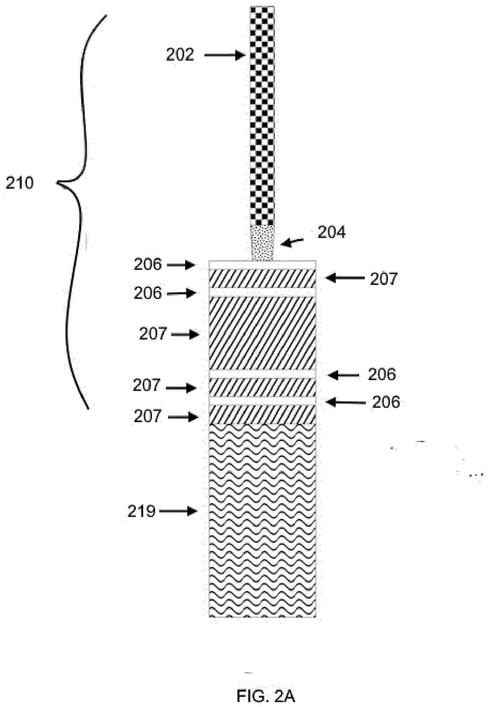

FIG. 2A shows the polygate patterning along the fin (210). A gate hard mask (202) is required to pattern the polysilicon gate (204). This is the view along the axis along the fin (210). The fin (210) obscures the view of the gate (204). The semiconductor channels (206) are separate by sacrificial SiGe layers (207). The substrate (208) is below the fin (210) in the drawing. The fin (210) is grown on top of the substrate (219). The fin (210) is composed of the epitaxially grown superlattice made of Si (206) and SiGe (207) layers.

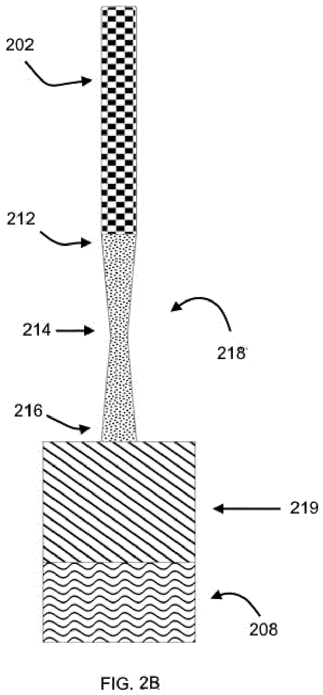

FIG. 2B is a drawing along the offset axis A'-A' to the fm. The drawing illustrates the resulting patterning of the gate (218).

In this embodiment there are two (2) etching processes beginning from the upper portion of the gate (212) and then the bottom of the gate (216). Upper includes "top", bottom includes "lower", and taper includes "curve". In this embodiment the surface is convex. However, the surface can be concave. It may also be a linear surface or non-linear. In this embodiment the middle (214) is narrower than the top (212) and bottom (216) of the gate (218). In this embodiment the opposing sides of the gate (218) are the same. However, the opposing sides may also be different. The shallow trench isolation (219) is made of dielectric like SiO₂ and isolates different fins from each other.

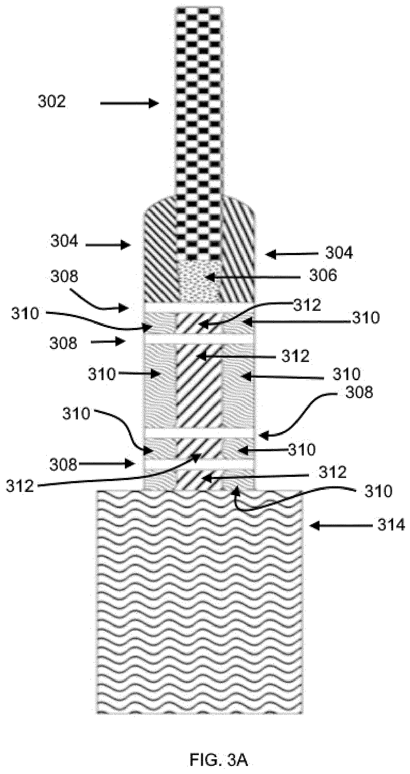

FIG. 3a along the B'-B' axis of the fin. The gate (306) is obscured in this drawing by the fin. This drawing illustrates formation of inner spacers (310). Source and drain regions are recessed and sacrificial SiGe layers (312) are partially etched away, and the resulting cavities are filled with dielectric of inner spacers (314). The thickness of these spacers is determined by SiGe etching and, thus, decoupled from the outer spacers (304).

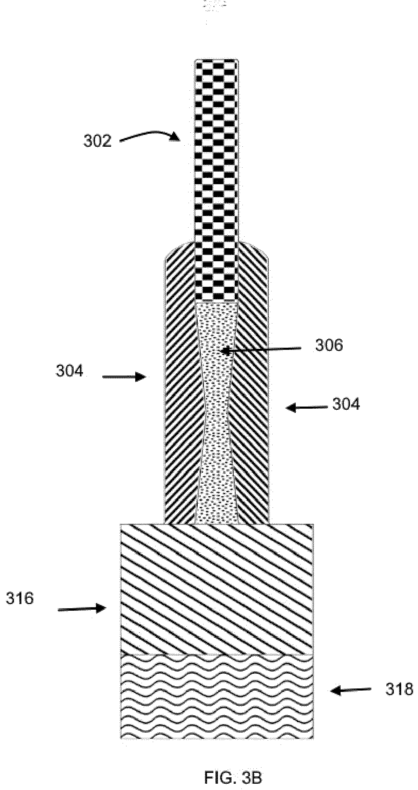

FIG. 3b is along the A'-A' axis and as it is offset from the fin. As inner spacers are formed only within the fin region, they are not visible here. However, outer spacers (304) formed around the polysilicon gate (304) are well illustrated.

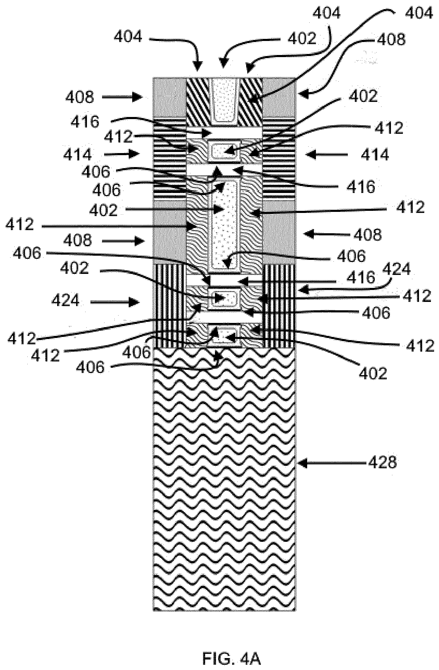

FIG. 4a is along the B'-B' axis along the fin. The final CFET device structure is shown albeit without source and drains electrodes. Polysilicon gate is etched away and 1) interfacial gate oxide (406) is formed around channels (416), 2) high-k dielectric (404), and 3) metal gate (402) are formed instead replicating tapered shape of the original polysilicon gate structure. Inner spacers (412) prevented gate to extend towards source and drain regions.

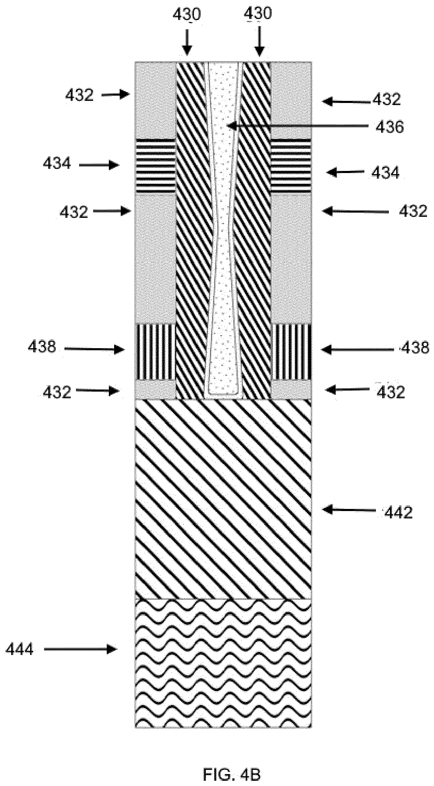

FIG. 4b is along the A'-A' fin offset axis and it indicates that source and drain sub-regions (434) for NMOS, and (438) for PMOS) are further away from the gate electrode (436) in the middle of the structure because of gate electrode tapering. Outer spacers (430) provide electrical isolation between the gate and source/drain regions. Inter-layer dielectric (432) isolates source and drain sub-regions the gate rests on the shallow trench isolation (442) and substate (444).

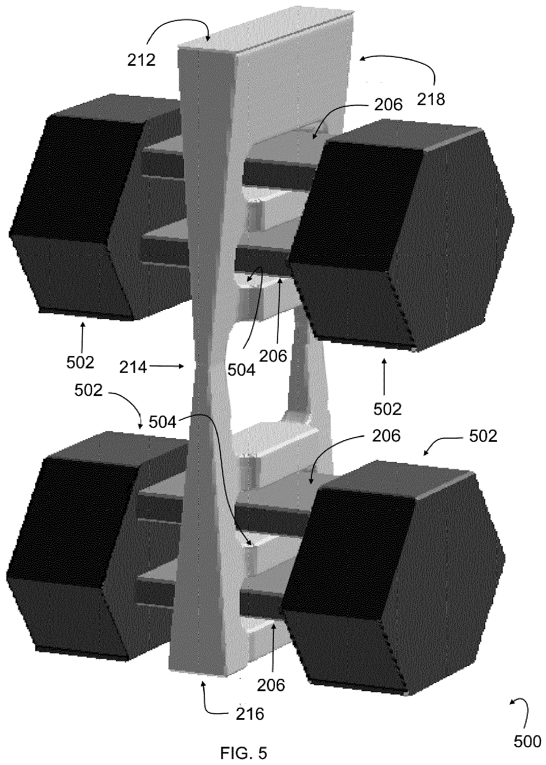

FIG. 5 indicates 3D view of the final CFET structure 500 with most of features hidden from the view. Instead, it highlights how the final tapered metal gate 218 and where channels and source drain regions are positioned. The gate 218 having a top 212, middle 214 and bottom portions 216 as referred to previously. The semiconductor channels 206 are surrounded by the gate. at each end of the semiconductor sheets are source/drain regions 502: two for NMOS, and two for PMOS.

The terms "comprises", "comprising", "includes", "including", "having" and their conjugates mean "including but not limited to".

The term "consisting of' means "including and limited to".

The term "consisting essentially of" means that the composition, method or structure may include additional ingredients, steps and/or parts, but only if the additional ingredients, steps and/or parts do not materially alter the basic and novel characteristics of the claimed composition, method or structure.

As used herein, the singular form "a", "an" and "the" include plural references unless the context clearly dictates otherwise.

It is appreciated that certain features of the invention, which are, for clarity, described in the context of separate embodiments, may also be provided in combination in a single embodiment. Conversely, various features of the invention, which are, for brevity, described in the context of a single embodiment, may also be provided separately or in any suitable subcombination or as suitable in any other described embodiment of the invention. Certain features described in the context of various embodiments are not to be considered essential features of those embodiments, unless the embodiment is inoperative without those elements. Although the invention has been described in conjunction with specific embodiments thereof, it is evident that many alternatives, modifications and variations will be apparent to those skilled in the art. Accordingly, it is intended to embrace all such alternatives, modifications and variations that fall within the spirit and broad scope of the appended claims.

It is the intent of the Applicant(s) that all publications, patents and patent applications referred to in this specification are to be incorporated in their entirety by reference into the specification, as if each individual publication, patent or patent application was specifically and individually noted when referenced that it is to be incorporated herein by reference. In addition, citation or identification of any reference in this application shall not be construed as an admission that such reference is available as prior art to the present invention. To the extent that section headings are used, they should not be construed as necessarily limiting. In addition, any priority document(s) of this application is/are hereby incorporated herein by reference in its/their entirety.

## Claims

1. A semiconductor device (100) comprising:
a substrate; and
a fin (210) formed on the substrate (208); and
a source region formed on the substrate (208) at one end of the fin (210) and a drain region formed on the other end of the fin, and
a gate (304) formed around the fin, wherein the gate (204) comprises opposing edges extending from top to bottom of the gate, wherein the opposing edges (304A), (304B) of the gate along the fin (210) have a concave or convex profile from top (306) to bottom (310) of the gate (304).

2. A semiconductor device (100) according to claim 1, wherein each of the opposing edges (304A), (304B)omprises an upper section (306) and a lower section (310) from top to bottom of the gate, and wherein the upper section (306) and the lower section (310) have different edge profile along the fin (210).

3. A semiconductor device (100) according to claim 1, wherein each of the opposing edges (304A), (304B) comprises an upper section (306), a middle section (308) and a bottom section (310) from top to bottom of the gate and wherein the middle section (308) is narrower or wider than the top section and the bottom section along the fm.

4. A semiconductor device according to claim 1, wherein each of the opposing edges has a curved surface with a different radius of curvature from top to bottom of the gate.

5. A semiconductor device (100) according to claim 2, wherein the upper section (306) has a linear profile tapered from top to bottom of the upper section (306) and the lower section (310) has a linear profile tapered from bottom to top of the lower section (310).

6. A semiconductor device (100) according to any one of the previous claims, wherein the gate (304) comprises a plurality of channels (506) being stacked on top of each other, and wherein the plurality of channels is wrapped by an electrode of the gate.

7. A semiconductor device (100) according to claim 6, wherein both the source region and the drain region comprise of two electrically isolated sub-regions, each sub-region being vertically stacked and adjacent to each other, wherein the one of the subregions is n-doped forming a NMOS device and the other subregion is p-doped forming a PMOS device.

8. A semiconductor device (100) according to any one of previous claims, wherein the gates, source region and drain region isolated from each other by spacers (504), wherein the spacers define dielectric spaces between conducting features.

9. A semiconductor device (100) according to claim 8, wherein the spacers (504) on the side of the gates are outer spacers.

10. A semiconductor device (100) according to claim 8 claims, wherein the spacers between cavities are inner spacers, wherein the inner spacers are positioned for each cavity defining the gate length.

11. A method for fabricating a semiconductor device (100), comprising:
providing a substrate; and
forming a fin on the substrate; and
forming a source region at one end of the fin and a drain region on the other end of the fin, and
forming a gate around the fin, wherein the gate comprises opposing edges extending from top to bottom of the gate,
wherein forming the gate around the fin comprises patterning the opposing edges of the gate along the fin with two or
more etching processes being performed successively, so that the opposing edges of the gate along the fin have a concave or convex profile from top to bottom of the gate.

12. A method for fabricating a semiconductor device according to claim 11, wherein the patterning the opposing edges comprises:
performing a first etching process to form an upper section of the opposing edges of the gate; and
performing a second etching process to form a lower section of the opposing edges of the gate, wherein the first etching processes and the second etching process, the upper section and the lower sections of the gate have different edge profiles along the fin.

13. A method for fabricating a semiconductor device (100) according to claim 12, wherein the upper section has a linear profile tapered from top to bottom of the upper section and the lower section has a linear profile tapered from bottom to top of the lower section.

14. A method for fabricating a semiconductor device (100) according to claim 12, wherein patterning the opposing edges comprises:
performing a first etching process to form a top section of the opposing edges of the gate; and
performing a second etching process to form a middle section of the opposing edges of the gate; and
performing a third etching process to form a bottom section of the opposing edges of the gate, wherein the first etching processes, the second etching process and the third etching process are different so that the middle section is narrower or wider than the top section and the bottom section along the fm.

## Amended claims

### Amended claims in accordance with Rule 137(2) EPC.

1. A semiconductor device (100) comprising:
a substrate; and
a fin (210) formed on the substrate (208); and
a source region formed on the substrate (208) at one end of the fin (210) and a drain region formed on the other end of the fin, and
a gate (304) formed around the fin, wherein the gate (204) comprises opposing edges extending from top to bottom of the gate, wherein the opposing edges (304A), (304B) of the gate along the fin (210) have a concave or convex profile from top (306) to bottom (310) of the gate (304);
wherein each of the opposing edges (304A), (304B) comprises an upper section (306), a middle section (308) and a bottom section (310) from top to bottom of the gate and wherein the middle section (308) is wider than the top section and the bottom section along the fin; and
wherein the fin (210) comprises a plurality of channels (206) being stacked on top of each other, and wherein the plurality of channels (206) is wrapped by an electrode of the gate.

2. A semiconductor device (100) according to claim 1, wherein both the source region and the drain region comprise of two electrically isolated sub-regions, each sub-region being vertically stacked and adjacent to each other, wherein the one of the subregions is n-doped forming a NMOS device and the other subregion is p-doped forming a PMOS device.

3. A semiconductor device (100) according to any one of previous claims, wherein the gates, source region and drain region isolated from each other by spacers (504), wherein the spacers define dielectric spaces between conducting features.

4. A semiconductor device (100) according to claim 3, wherein the spacers (504) on the side of the gates are outer spacers.

5. A semiconductor device (100) according to any one of previous claims, wherein spacers between channels are inner spacers, wherein the inner spacers are positioned for each channel defining the gate length.

6. A method for fabricating a semiconductor device (100), comprising:
providing a substrate; and
forming a fin on the substrate; and
forming a source region at one end of the fin and a drain region on the other end of the fin, and
forming a gate around the fin, wherein the gate comprises opposing edges extending from top to bottom of the gate, wherein forming the gate around the fin comprises patterning the opposing edges of the gate along the fin with two or more etching processes being performed successively, so that the opposing edges of the gate along the fin have a concave or convex profile from top to bottom of the gatel
wherein patterning the opposing edges comprises:
performing a first etching process to form a top section of the opposing edges of the gate; and
performing a second etching process to form a middle section of the opposing edges of the gate; and
performing a third etching process to form a bottom section of the opposing edges of the gate, wherein the first etching processes, the second etching process and the third etching process are different so that the middle section is wider than the top section and the bottom section along the fin.
